Europäisches Patentamt

European Patent Office

Office européen des brevets

(19)

(11) Veröffentlichungsnummer : **0 089 509**
**B1**

(12) **EUROPÄISCHE PATENTSCHRIFT**

(45) Veröffentlichungstag der Patentschrift :
28.05.86

(51) Int. Cl.⁴ : **B 41 N 1/08, C 25 D 13/04**

(21) Anmeldenummer : 83101812.2

(22) Anmeldetag : 24.02.83

(54) Verfahren zur elektrophoretischen Aufbringung von strahlungsempfindlichen Beschichtungen auf Metallträger und die Verwendung des beschichteten Materials als Offsetdruckplatte.

(30) Priorität : 18.03.82 US 359458

(43) Veröffentlichungstag der Anmeldung :
28.09.83 Patentblatt 83/39

(45) Bekanntmachung des Hinweises auf die Patenterteilung : 28.05.86 Patentblatt 86/22

(84) Benannte Vertragsstaaten :
DE GB NL

(56) Entgegenhaltungen :
DE-A- 2 243 178
DE-A- 2 301 075
US-A- 3 468 725
US-A- 3 658 662
US-A- 3 756 826
US-A- 3 963 568
CHEMICAL ABSTRACTS, vol. 88, no. 8, 20 Februar 1978, Seite 372, No. 56381j, Columbus, Ohio, US H. TAKAHASHI et al.: "Anodization of aluminum in neutral borate baths"

(73) Patentinhaber : AMERICAN HOECHST CORPORATION
Route 202-206 North
Somerville, N.J. 08876 (US)

(72) Erfinder : Walls, John E.
46, Center Street
Annandale New Jersey 08801 (US)
Erfinder : Dunder, Thomas A.
15 Fine Road
High Bridge New Jersey 08829 (US)

(74) Vertreter : Euler, Kurt Emil, Dr. et al
KALLE Niederlassung der Hoechst AG Rheingaustrasse 190 Postfach 3540
D-6200 Wiesbaden 1 (DE)

**0 089 509**

**Beschreibung**

Die Erfindung betrifft ein Verfahren zur ein- oder beidseitigen elektrophoretischen Beschichtung von Metallträgermaterialien mit den Stufen a) elektrochemische Erzeugung einer hydrophilen Zwischenschicht und b) elektrophoretisches Aufbringen von strahlungsempfindlichen Beschichtungen. Das beschichtete Material findet bevorzugt Verwendung als Offsetdruckplatte.

Bei der Herstellung von Offsetdruckplatten wird eine oftmals aufgerauhte und hydrophilierte Trägerplatte aus Metall (z. B. Aluminium) mit einer strahlungsempfindlichen Masse beschichtet. Diese strahlungsempfindliche Schicht wird beispielsweise durch eine Vorlage mit UV-Strahlung belichtet und mit einem geeigneten Entwickler zur Erzeugung der beim späteren Drucken benötigten Bildstellen und Nichtbildstellen entwickelt. Mit der so hergestellten Druckform können dann auf einer Druckmaschine viele tausend Drucke hergestellt werden. Eine ähnliche Technologie, jedoch meist ohne den Druckvorgang, ist auch von der Anwendung von Trocken- oder Flüssigresists her bekannt.

Die strahlungsempfindliche Masse wird in der Regel nach einem mechanischen Beschichtungsverfahren auf eine Trägerplatte oder -folie oder in großtechnischen Anlagen zur Herstellung von strahlungsempfindlich vorbeschichteten Druckplatten auf ein Trägerband aufgebracht, und zwar beispielsweise durch Aufreiben von Hand, Aufschleudern, Auftragen mit einem Pinsel, Aufsprühen auf die Oberfläche oder — insbesondere in Bandanlagen — das Gravur (Walzen mit Näpfchen) beschichten, das Fließer (Gießkopf) beschichten, Vorhangbeschichten oder das Tauchbeschichten, bei dem ein Metallband durch ein Bad aus der strahlungsempfindlichen Masse gezogen und die überschüssige Beschichtungsmasse anschließend abgerakelt wird, sowie das Meniskusbeschichten. In den meisten dieser Verfahren wird die strahlungsempfindliche Masse in einem Lösemittelsystem aufgebracht, das im wesentlichen organisch Lösemittel enthält, die durch aufwendige Trockensysteme entfernt werden müssen und deren Aufarbeitung aus ökologischen Gründen sehr aufwendig ist.

Aus der US-A 3 756 826 ist ein Verfahren zur Behandlung von Aluminiumplatten bekannt, die zur Aufnahme lichtempfindlicher Schichten dienen. Bei diesem Verfahren wird in einer ersten Stufe eine Aluminiumoberfläche in einem Elektrolyten anodisiert, der einen wasserlöslichen Ester einer zwei- oder dreibasischen organischen Säure enthält, die wenigstens eine Hydroxylgruppe aufweist. Als zweibasische Säuren werden Weinsäure, Äpfelsäure und als Salz das Ammoniumsalz einer dreibasischen Säure, nämlich die Zitronensäure, verwendet. Nach verschiedenen Spülschritten wird dann die lichtempfindliche Schicht ohne Anwendung von Strom nach konventionellen Methoden aufgebracht. Die Anzahl der so hergestellten guten Drucke belief sich jedoch auf lediglich 1700, was auf eine mangelnde Haftung zwischen Träger und Schicht und/oder auf mangelnde Hydrophilie zurückzuführen sein dürfte.

Aufgabe der vorliegenden Erfindung ist es, ein Verfahren zum ein- oder beidseitigen Aufbringen von strahlungsempfindlichen Reproduktionsschichten auf Metallträgermaterialien, insbesondere solchen auf der Basis von Aluminium oder einer seiner Legierungen, vorzuschlagen, das ohne größere Mengen an organischen Lösemitteln in der aufzubringenden Schichtmasse durchgeführt werden kann und zu einem beschichteten Material führt, das insbesondere als Offsetdruckplatte geeignet ist, d. h. einerseits eine hydrophile Materialoberfläche zeigt (wichtig für die späteren Nichtbildstellen der Druckform), andererseits aber auch eine starke Haftung durch Wechselwirkung mit der Beschichtung eingeht (wichtig für die späteren Bildstellen der Druckform, für die Lager- und Transportfähigkeit und für die gewünschte hohe Druckauflage).

Die Erfindung geht aus von dem bekannten Verfahren gemäß US-A-37 56 826 zur ein- oder beidseitig elektrophoretischen Beschichtung von Metallträgermaterialien in einem mindestens eine auf das Trägermaterial aufzubringende organische Verbindung enthaltenden wäßrigen Elektrolyten mit den Stufen a) elektrochemische Behandlung der Oberfläche des Metallträgermaterials in einem wäßrigen Elektrolyten zur Erzeugung einer hydrophilen Zwischenschicht und b) elektrophoretische Beschichtung. Das erfindungsgemäße Verfahren ist dann dadurch gekennzeichnet, daß in der Stufe a) der wäßrige Elektrolyt mindestens eine wasserlösliche Verbindung aus der Gruppe der Sulfon-, Phosphon- oder mindestens dreibasischen Carbonsäuren, der noch mindestens eine saure funktionelle Gruppe aufweisenden Phosphorsäureester oder der Alkali- und Ammoniumsalze dieser Säuren oder Ester und in der Stufe b) der wäßrige Elektrolyt mindestens eine wasserlösliche oder in Wasser dispergierbare strahlungsempfindliche Verbindung enthält.

In bevorzugten Ausführungsformen des erfindungsgemäßen Verfahrens enthält in der Stufe a) der wäßrige Elektrolyt mindestens eine der organischen Säuren oder Ester in einem Anteil von 0,5 bis 300 g/l und gegebenenfalls zusätzlich Phosphorsäure und/oder Phosphorige Säure, oder er enthält mindestens eines der organischen Salze und zusätzlich mindestens ein Salz mit einem Silikat-, Fluoroborat-, Tetraborat- oder Pentaborat-Anion und einem einwertigen Kation (z. B. Na+, K+ oder NH4+). Das erfindungsgemäße Verfahren bringt gegenüber den konventionellen mechanischen Beschichtungsverfahren u. a. die folgenden Verbesserungen. Die Haftung zwischen dem Trägermaterial und der Reproduktionsschicht ist sehr gut. Beim Belichten und Entwickeln von daraus hergestellten Offsetdruckplatten zeigen die Bildstellen der Druckform eine hohe Auflösung und Intensität, die Reproduktionsschicht hat eine außergewöhnlich hohe Belichtungsgeschwindigkeit, und die Druckform zeigt eine ausgezeichnete gleichmäßige Haftung und Abriebfestigkeit der druckenden Teile. Das Verfahren

2

kann diskontinuierlich, aber auch bevorzugt kontinuierlich in modernen Bandanlagen durchgeführt werden.

Bei dem erfindungsgemäßen Verfahren wird von platten-, folien- oder bandförmigen Metallträgermaterial ausgegangen, das beispielsweise aus Stahl, Stahl/Chrom, Stahl/Aluminium, Zink oder insbesondere aus Aluminium oder einer seiner Legierungen wie den Typen « 1100 » oder « 3003 », d. h. beispielsweise solchen mit einem Gehalt von mehr als 98,5 % an Al und Anteilen an Si, Fe, Ti, Cu und Zn, besteht. Die Materialien werden im allgemeinen noch mechanisch (z. B. durch Bürsten und/oder mit Schleifmittelbehandlungen), chemisch (z. B. durch Ätzmittel) und/oder elektrochemisch (z. B. durch Wechselstrombehandlung in wäßrigen Säure- oder Salzlösungen) aufgerauht. Dieser Aufrauhstufe kann sich auch noch eine anodische Oxidation anschließen, um beispielsweise die Abriebs- und die Haftungseigenschaften der Oberfläche zu verbessern. In der Stufe a) wird dann das Trägermaterial mit einer hydrophilen Zwischenschicht versehen. Dazu sind beispielsweise die folgenden Verfahren besonders geeignet :

In der erfindungsgemäßen Stufe b) wird das mit einer hydrophilen Zwischenschicht versehene Trägermaterial elektrophoretisch in einem wäßrigen Elektrolyten beschichtet, der mindestens eine wasserlösliche oder in Wasser dispergierbare strahlungsempfindliche Verbindung und gegebenenfalls mindestens ein wasserlösliches oder in Wasser dispergierbares Bindemittel enthält. Das Trägermaterial wird dabei, abhängig von der Art der strahlungsempfindlichen Verbindung und gegebenenfalls des Harzes, entweder als Kathode oder Anode in einem Gleichstromkreis geschlatet. Bevorzugt wird das Verfahren so durchgeführt, daß die elektrophoretisch Beschichtung zu einer negativ-arbeitenden strahlungsempfindlichen Reproduktionsschicht führt, wobei die dort eingesetzten strahlungsempfindlichen Verbindungen insbesondere Diazoniumsalze sind, deren organischer Teil bereits ein Kation ist oder bei Anlegen einer elektrischen Spannung zur Kathode wandert, d. h. in dieser bevorzugten Ausführungsform wird das Trägermaterial natürlich als Kathode geschaltet werden.

Bei der Ausführung der letztgenannten Verfahrensvariante wird die im wesentlichen wasserlösliche strahlungsempfindliche Verbindung, insbesondere ein wasserlösliches Diazoniumsalz, in Wasser, vorzugsweise in entsalztem Wasser, gelöst. Falls gewünscht, können auch noch damit verträgliche Komponenten wie die bereits erwähnten Bindemittel, bis zu einem Anteil von maximal 10 % organische Lösemittel oder Hilfsmittel zugesetzt werden. Das Trägermaterial wird dann als Kathode geschaltet und in das elektrolytische Bad ein- bzw. untergetaucht, während über mindestens eine weitere, in dem Bad angeordnete Elektrode eine elektromotorische Kraft angewendet wird, d. h. ein Strom fließen und wirken kann. Dabei scheidet sich eine sehr dünne, gut haftende Schicht auf der Basis der strahlungsempfindlichen Verbindung auf dem Trägermaterial ab. Das so beschichtete Trägermaterial wird dann beispielsweise mit Wasser abgewaschen und getrocknet. Sofern es in Bandform vorliegt, wird es aufgerollt oder in Platten aufgeteilt, oder größere Platten oder Folien werden in kleinere Formate aufgeteilt.

Bevorzugt eingesetzte Diazoniumsalze und ihre Herstellungsverfahren sind :

Das Vorkondensationsprodukt von 4,4'-Bis-methoxymethyldiphenylether mit Phosphorsäure wird anschließend mit 3-Methoxy-diphenylamin-4-diazoniumsulfat in Phosphorsäure kondensiert und als Phosphat isoliert. Das als Phosphat isolierte Produkt aus der Kondensationsreaktion zwischen Diphenylamin-4-diazoniumsulfat und 4,4'-Bis-methoxymethyl-diphenylsulfid in Phosphorsäure wird anschließend mit 4-Tolylmercapto-2,5-diethoxy-benzoldiazoniumchlorid und Paraformaldehyd in Schwefelsäure kondensiert und als Sulfat isoliert. Diphenylamin-4-diazoniumsulfat wird mit 4,4'-Bis-methoxymethyl-diphenylether in Phosphorsäure kondensiert und als Phosphat isoliert.

3-Methoxy-diphenylamin-4-diazoniumsulfat wird mit 4,4'-Bis-hydroxymethyl-diphenylsulfid in Phosphorsäure kondensiert und als Phosphat isoliert. 4-Tolylmercapto-2,5-dibutoxy-benzoldiazoniumchlorid und Diphenylamin-4-diazoniumsulfat werden mit Paraformaldehyd in Schwefelsäure kondensiert und als Sulfat isoliert. Diese Diazoniumsalz-Polykondensationsprodukte und Verfahren zu ihrer Herstellung werden beispielsweise in der DE-A 20 24 244 (= US-A 3 867 147), der EP-A 0 061 150 und der prioritätsgleichen und am gleichen Tag eingereichten Patentanmeldung ... (interne Bezeichnung « 82/K088 ») mit dem Titel « Lichtempfindliche Mischkondensate und damit hergestelltes lichtempfindliches Aufzeichnungsmaterial » beschrieben.

Der Anteil der strahlungsempfindlichen Verbindung in der wäßrigen Elektrolytlösung beträgt im allgemeinen 1 bis 150 g/l, insbesondere 5 bis 100 g/l und vorzugsweise 10 bis 30 g/l. Im Regelfall wird bei der elektrophoretischen Beschichtung Gleichstrom verwendet. Die Polarität des Trägers wird je nach den elektrischen Ansprechmerkmalen der strahlungsempfindlichen Verbindung gewählt. So sind Diazoniumsalze im organischen Teil im allgemeinen kationisch ; um also das Diazoniumsalz auf der Trägeroberfläche abzuscheiden, muß der Träger als Kathode geschaltet werden. Die der elektromotorischen Kraft zugrunde liegende Spannung, die normalerweise ausreicht, um die strahlungsempfindliche Verbindung zur Aluminiumoberfläche zu treiben, liegt insbesondere bei 1 bis 30 V, vorzugsweise bei 10 bis 30 V ; es können bei Anwesenheit von Hilfsstoffen und/oder abscheidbaren Bindemitteln auch höhere Werte, beispielsweise von bis zu 100 V, erforderlich werden. Im allgemeinen wird für die Dauer bis zu etwa 60 sec, insbesondere von 5 bis 30 sec und bevorzugt von 20 bis 30 sec die Spannung angelegt. Die Elektrolyttemperatur wird im allgemeinen unter etwa 50 °C, insbesondere zwischen 5 und 40 °C und vorzugsweise zwischen 10 und 35 °C gehalten. Der Abstand Kathode-Anode beträgt auf beiden Seiten eines Aluminiumbandes, einer Aluminiumfolie oder -platte 1 bis 10 cm, insbesondere 2 bis 7 cm und bevorzugt 2,5 bis 5 cm. Auf jede Seite des zu behandelnden Aluminiums wirkt dann eine Stromdichte von 1,4 bis 30 A/dm², vorzugsweise von 2 bis 20 A/dm² und ganz besonders bevorzugt von 6 bis 15 A/dm² ein.

Das Schichtgewicht der elektrophoretisch aufgebrachten strahlungsempfindlichen Reproduktionsschicht auf dem Metallträger liegt generell zwischen 20 und 600 mg/m², insbesondere zwischen 100 und 400 mg/m² und bevorzugt zwischen 200 und 240 mg/m². Sowohl die Stufe a) als auch die Stufe b) des erfindungsgemäßen Verfahrens, ebenso wie weitere Vor- oder Nachbehandlungsschritte können ein- oder beidseitig ausgeführt werden.

Wenn eine strahlungsempfindliche Verbindung für den Einsatz in dieser Erfindung geeignet sein soll, so muß sie bestimmte Kriterien erfüllen. Die Verbindung muß in Wasser dispergierbar oder noch besser im wesentlichen, vorzugsweise zu mindestens etwa 99 % wasserlöslich sein. Als Elektrolytflüssigkeit wird bevorzugt entsalztes Wasser verwendet, das eine Leitfähigkeit von wenigstens 1 M$\Omega$ haben soll. Eine Lösung von 10 g einer geeigneten strahlungsempfindlichen Verbindung in einem Liter entsalztem Wasser sollte nach dem Filtrieren und Trocknen des Filtrats einen Rückstand von insbesondere maximal 0,1 g aufweisen. Darüber hinaus ist das folgende Vorprüfverfahren hilfreich : Eine 4 cm² große Probe aus Aluminium in Offsetqualität, deren Oberfläche für die elektrochemische Abscheidung wie vorstehend beschrieben hydrophiliert wurde, wird in eine 1 %ige Lösung der zu prüfenden strahlungsempfindlichen Verbindung in entsalztem Wasser zwischen zwei Bleielektroden gehängt. Die Bleielektroden sind dabei die Anoden, und die Aluminiumprobe ist die Kathode. Jede Seite des Aluminiums wird mit einer Stromdichte von 1,4 A/dm² beaufschlagt. Wenn sich eine teerartige Ablagerung oder Ausfällung an den Elektroden bildet oder eine Gasentwicklung (bei Diazoniumsalzen aus Stickstoff) in der Lösung beobachtet wird, ist die strahlungsempfindliche Verbindung für das erfindungsgemäße Verfahren weniger oder nicht geeignet.

In der Beschreibung und den nachfolgenden Beispielen sind %-Angaben — wenn nichts anderes ausgeführt wird — auf das Gewicht bezogen, Gew.-Teile verhalten sich zu Vol.-Teilen wie g zu cm³.

## Beispiel 1

6,0 Gew.-Teile des als Phosphat isolierten Reaktionsproduktes aus Diphenylamin-4-diazoniumsulfat und Paraformaldehyd in Phosphorsäure werden in 594 Vol.-Teilen entsalztem Wasser gelöst. Diese Lösung wird in ein Elektrolytgefäß gegeben, in dem zwei Bleielektroden im Abstand von 10 cm voneinander angeordnet sind. Zwischen den beiden Elektroden und gleichweit von jeder Elektrode entfernt befindet sich eine Aluminiumplatte, die bereits durch anodische elektrochemisch Abscheidung von Polyvinylphosphonsäure hydrophiliert worden ist. Es wird ein Stromkeis gebildet, in dem das Aluminium als die Kathode und die beiden Bleielektroden als Anoden wirken, wobei eine Spannung von 30 V Gleichstrom angelegt und der Stromverbrauch mit 110 Coulomb/dm² gemessen wird. Die beidseitig beschichtete Platte wird herausgenommen, grundlich mit Wasser abgespült und trockengetupft. Anschließend wird eine der beiden Plattenoberflächen mit UV-Strahlung (einer mit 170 mJ/cm² gemessenen Energie) unter einer Negativ-Vorlage belichtet. Die belichtete Platte wird mit einem subtraktiven Entwickler (siehe US-A 4 308 340) mit einem Gehalt an n-Propano, 2-Propoxy-ethanol, $(NH_4)_2SO_3$, nichtionogenem Tensid, Dextrin, $NaSO_4$ und Wasser entwickelt und dann mit Druckfarbe eingefärbt, um das Bild betrachten zu können. Die Belichtung unter einem 21-stufigen Stauffer-Stufenkeil ergibt eine gleichmäßig geschwärzte Stufe 8 und 5 angedeutete Keilstufen. Der Hintergrund der Druckform ist sauber und frei von Druckfarbe, und das Bild hat eine hohe Auflösung und steht im Verhältnis von 1 : 1 zu der für die Belichtung benutzten Vorlage. Die ebenfalls strahlungsempfindlich beschichtete Rückseite der Platte wird wie vorstehend verarbeitet und erweist sich als völlig gleichwertig. Bei einer weiteren Probe wird die strahlungsempfindliche Beschichtung entfernt und deren Gewicht mit 96 mg/m² ermittelt. In gleicher Weise wird eine vom Format her gesehen größere Druckplatte hergestellt und beim Einsatz auf einer Druckmaschine getestet. Die Platte liefert 70 000 Drucke von guter Qualität, bevor die Wiedergabe als unannehmbar angesehen wird.

## Vergleichsbeispiel V1

Es wird nach den Angaben des Beispiels 1 verfahren, aber das Aluminium ohne Anlegen einer elektrischen Spannung während 60 sec in die, die strahlungsempfindliche Verbindung enthaltende Lösung eingetaucht. Die Platte wird aus der Lösung genommen, abgespült und trockengetupft. Auf beiden Seiten der Platte hat die strahlungsempfindliche Beschichtung ein Gewicht von 27 mg/m². Nach dem Belichten mit UV-Strahlung, Entwickeln und Einfärben ergibt die Graukeilablesung eine gleichmäßig geschwärzte Stufe 4 und 2 angedeutete Stufen. In gleicher Weise wird eine vom Format her größere Platte beschichtet. Die Belichtung wird soweit verstärkt, daß sich auf dem Graukeil eine gleichmäßig geschwärzte Stufe 7 zeigt. Die Durckform wird dann als Vergleichsprobe auf einer Bogendruckmaschine getestet ; sie liefert nur 6 000 einwandfreie Drucke, danach ist die Druckqualität schlecht.

## Beispiel 2 und Vergleichsbeispiel V2

Zur Auswertung auf der Druckmaschine wird eine Platte wie in Beispiel 1 beschrieben vorbereitet. In diesem Fall wird allerdings nicht subtraktiv, sondern mit einem die Bildstellen verstärkenden additiven (Lack-) Entwickler (« Western Jet Black » von der Firma Western Litho) entwickelt. Auf einer Bogendruckmaschine lassen sich 185.000 Drucke von guter Qualität herstellen. Zum Vergleich (V2) wird die Platte aus dem Vergleichsbeispiel V1 ebenfalls mit dem additiven Entwickler entwickelt und im Druckversuch bewertet. Diese Platte liefert nur 37 000 einwandfreie Drucke.

### Beispiele 3 bis 10 und Vergleichsbeispiele V3 bis V6

Nachfolgend sind die Ergebnisse, die man mit verschiedenen Verbindungen unter den angegebenen Verfahrensbedingungen erhält, tabellarisch aufgeführt. Diese Verbindungen werden wie folgt bezeichnet :

D-1 Diphenylamin-4-diazoniumsulfat mit 4,4'-Bis-methoxymethyldiphenylether in Phosphorsäure kondensiert und als Phosphat isoliert,

D-2 3-Methoxy-diphenylamin-4-diazoniumsulfat mit 4,4'-Bis-hydroxymethyl-diphenylsulfid in Phosphorsäure kondensiert und als Phosphat isoliert,

D-3 4-Tolylmercapto-2,5-dibutoxy-benzoldiazoniumchlorid und Diphenylamid-4-diazoniumsulfat mit Paraformaldehyd in Schwefelsäure kondensiert und als Sulfat isoliert,

D-4 das Vorkondensationsprodukt von 4,4'-Bis-methoxymethyl-diphenylether mit Phosphorsäure, kondensiert mit 3-Methoxy-diphenylamin-4-diazoniumsulfat in Phosphorsäure und als Phosphat isoliert, und

D-5 das Produkt aus der Kondensationsreaktion zwischen Diphenylamin-4-diazoniumsulfat und 4,4'-Bis-methoxymethyl-diphenylsulfid in Phosphorsäure, als Phosphat isoliert und anschließend mit 4-Tolylmercapto-2,5-dibutoxy-benzoldiazoniumchlorid und Paraformaldehyd in Schwefelsäure kondensiert und als Sulfat isoliert.

Die Vergleichsbeispiele V3 bis V6 betreffen Beschichtungsverfahren, bei denen die Beschichtung ohne Anwendung eines elektrischen Potentials aufgebracht wird. Die übrigen Beispiele 3 bis 10 zeigen die durch das erfindungsgemäße Verfahren erreichten Verbesserungen. Im Beispiel 1 wird die strahlungsempfindliche Beschichtung aus der Lösung mit Hilfe von Gleichstrom aufgebracht. Verglichen mit Vergleichsbeispiel V1, in dem nach einem bekannten Verfahren gearbeitet wird, ist der auffälligste Unterschied die Größenordnung, in der die Auflage zunimmt. Die gleiche Verbesserung zeigt sich beim Vergleich der Vergleichsbeispiele V3 und V4 mit den Beispielen 3 und 7. Während die bisher genannten Platten substraktiv entwickelt werden, weisen Platten, die additiv entwickelt werden, gleichfalls einen erheblichen Unterschied in der Auflagenhöhe auf. Wird beispielsweise die beschichtete Platte aus Beispiel 1 additiv entwickelt und mit der ebenso behandelten Platte aus Vergleichsbeispiel V1 verglichen, so stellt man bei der Platte aus Beispiel 1 eine Steigerung um das Fünffache fest. Das gilt in gleichem Maße für die Beispiele 8 und V6, in denen eine andere strahlungsempfindliche Verbindung in herkömmlicher Weise und elektrophoretisch aufgebracht wird. Auch hier ergibt sich eine Steigerung der Auflage um das Fünffache.

Die Auflagensteigerung einer Druckform ist jedoch nicht der einzige aus dem erfindungsgemäßen Verfahren resultierende Vorteil. Aus einem Vergleich der Vergleichsbeispiele V3, V4, V5 und V6 mit den Beispielen 3, 7, 8 und 9 wird ersichtlich, daß die Energiemenge, die man benötigt, um nach der Belichtung die gleiche gleichmäßig geschwärzte Stufe des Stufenkeils auf den Platten nach dieser Erfindung zu erhalten, gesenkt werden kann ; es wird immer die Energiemenge gewählt, die erforderlich ist, um nach dem Entwickeln und Einschwärzen eine gleichmäßig geschwärzte Keilstufe 6 zu erhalten.

(Siehe Tabelle Seite 6 ff.)

Tabelle

| B *) / V **) | strahlungs-empfindl. Verbindung | Konzentration der wißrigen Beschichtungs-lösung (%) | Verarbeitungs-bedingungen | Belich-tungs-energie $(mJ/cm^2)$ | Keilstufen gleichmäßig geschwärzt/angedeutet | Schicht-gewicht $(mg/m^2)$ | Auflagen-höhe (in 1000 Drucken) | Entwick-lertyp |
|---|---|---|---|---|---|---|---|---|
| V3 | D-1 | 1,0 | Tauchbehandlung bei Raumtemp. f. 60 sec, ab-gespült, trok-kengetupft | 85 | 6/5 | 30 | 7 | substrak-tiv |
| 3 | D-1 | 1,0 | 10 V Gleich-strom bei Raum-temp.,Verbrauch: 42 Coulomb/dm², abgespült, trockengetupft | 34 | 6/6 | 105 | 65 | substrak-tiv |
| 4 | D-2 | 0,5 | 10 V Gleich-strom bei Raum-temp.,Verbrauch: 31 Coulomb/dm², abgespült, trockengetupft | 19 | 6/5 | 88 | kein Druck-versuch | additiv |
| 5 | D-2 | 1,0 | 10 V Gleich-strom bei Raum-temp.,Verbrauch: 43 Coulomb/dm², abgespült, trockengetupft | 20 | 6/7 | 97 | kein Druck-versuch | additiv |

*) B = Beispiel    **) V = Vergleichsbeispiel

Tabelle (Fortsetzung I)

| B V | strahlungs-empfindl. Verbindung | Konzentration der wäßrigen Beschichtungs-lösung (%) | Verarbeitungs-bedingungen | Belichtungs-energie (mJ/cm²) | Keilstufen gleichmäßig geschwärzt/angedeutet | Schicht-gewicht (mg/m²) | Auflagen-höhe (in 1000 Drucken) | Entwick-lertyp |
|---|---|---|---|---|---|---|---|---|
| 6 | D-2 | 2,5 | 10 V Gleich-strom bei Raum-temp.,Verbrauch: 58 Coulomb/dm², abgespült, trockengetupft | 26 | 6/8 | 140 | kein Druck-versuch | additiv |
| V4 | D-3 | 1,0 | Tauchbehandlung bei Raumtemp. f. 60 sec, ab-gespült, trok-kengetupft | 144 | 6/2 | 26 | 7 | substrak-tiv |
| 7 | D-3 | 1,0 | 30 V Gleich-strom bei Raum-temp.,Verbrauch: 121 Coulomb/dm², abgespült, trockengetupft | 27 | 6/4 | 93 | 75 | substrak-tiv |
| V5 | D-3 | 1,0 | Tauchbehandlung bei Raumtemp. f. 60 sec, ab-gespült, trok-kengetupft | 136 | 6/3 | 28 | 43 | additiv |
| 8 | D-3 | 1,0 | 30 V Gleich-strom bei Raum-temp.,Verbrauch: 121 Coulomb/dm², abgespült, trockengetupft | 24 | 6/4 | 90 | 205 | additiv |

0 089 509

Tabelle (Fortsetzung II)

| B V | strahlungs-empfindl. Verbindung | Konzentration der wäßrigen Beschichtungs-lösung (%) | Verarbeitungs-bedingungen | Belich-tungs-energie $(mJ/cm^{2})$ | Keilstufen gleichmäßig geschwärzt/ angedeutet | Schicht-gewicht $(mg/m^2)$ | Auflagen-höhe (in 1000 Drucken) | Entwick-lertyp |
|---|---|---|---|---|---|---|---|---|
| V6 | D-4 | 1,0 | Tauchbehandlung bei Raumtemp. f. 60 sec, ab-gespült, trok-kengetupft | 14 | 6/5 | 31 | kein Druck-versuch | additiv |
| 9 | D-4 | 1,0 | 30 V Gleich-strom bei Raum-Temp.,Verbrauch: 78 Coulomb/dm$^2$, abgespült, trockengetupft | 9 | 6/6 | 78 | kein Druck-versuch | additiv |
| 10 | D-5 | 1,0 | 30 V Gleich-strom bei Raum-temp.,Verbrauch: 138 Coulomb/dm$^2$, abgespült, trockengetupft | 10 | 6/4 | 93 | 75 | substrak-tiv |

0 089 509

## Patentansprüche

1. Verfahren zur Herstellung eines Metallträgers mit lichtempfindlicher Schicht, wobei man a) ein- oder beidseitig die Oberfläche des Metallträgermaterials in einem wäßrigen Elektrolyten zur Erzeugung einer hydrophilen Zwischenschicht elektrochemisch behandelt und b) eine lichtempfindliche Schicht aufbringt, dadurch gekennzeichnet, daß in der Stufe a) mit einem wäßrigen Elektrolyten behandelt wird, der mindestens eine wasserlösliche Verbindung aus der Gruppe der Sulfon-, Phosphon- oder mindestens dreibasischen Carbonsäuren, der noch mindestens eine saure funktionelle Gruppe aufweisenden Phosphorsäureester oder der Alkali- und Ammoniumsalze dieser Säuren oder Ester enthält und daß man in der Stufe b) eine Schicht aus einem Elektrolyten unter Anwendung von Strom aufbringt, der mindestens eine wasserlösliche oder in Wasser dispergierbare strahlungsempfindliche Verbindung enthält.

2. Verfahren nach Anspruch 1, dadurch gekennzeichnet, daß man in Stufe b) eine Schicht aufbringt, die zusätzlich mindestens ein wasserlösliches oder in Wasser dispergierbares Bindemittel enthält.

3. Verfahren nach einem der Ansprüche 1 oder 2, dadurch gekennzeichnet, daß in der Stufe a) der wäßrige Elektrolyt mindestens eine der organischen Säuren oder Ester in einem Anteil von 0,5 bis 300 g/l und gegebenenfalls zusätzlich Phosphorsäure und/oder Phosphorige Säure enthält.

4. Verfahren nach einem der Ansprüche 1 oder 2, dadurch gekennzeichnet, daß in der Stufe a) der wäßrige Elektrolyt mindestens eines der organischen Salze und zusätzlich mindestens ein Salz mit einem Silikat-, Fluoroborat-, Tetraborat- oder Pentaborat-Anion und einem einwertigen Kation enthält.

5. Verfahren nach Anspruch 4, dadurch gekennzeichnet, daß in der Stufe a) organische Salze eingesetzt werden, die in wäßriger Lösung alkalisch reagieren und aus wäßrigen Lösungen der Säuren oder sauren Ester durch Titration mit einer wäßrigen Alkali- oder Ammoniumhydroxidlösung bis zum Erreichen eines alkalischen pH-Werts hergestellt werden.

6. Verfahren nach Anspruch 5, dadurch gekennzeichnet, daß die wäßrige Lösung 1 bis 80 g/l an Säuren oder sauren Estern enthält und der pH-Wert bei 8,0 bis 10,5 liegt.

7. Verfahren nach einem der Ansprüche 1 bis 3, dadurch gekennzeichnet, daß in der Stufe a) der wäßrige Elektrolyt Polybenzolphosphonsäure, Phytinsäure, Polyvinylphosphonsäure und/oder 2-Ethyl-hexanphosphonsäure enthält.

8. Verfahren nach Anspruch 1, 4, 5 oder 6, dadurch gekennzeichnet, daß in der Stufe a) der wäßrige Elektrolyt ein Salz der Polyvinylsulfonsäure, Polyvinylphosphonsäure, Phytinsäure, 2-Ethyl-hexanphosphonsäure und/oder eines hydrolysierten Copolymeren aus Vinylmethylether und Maleinsäureanhydrid enthält.

9. Verfahren nach einem der Ansprüche 1 bis 8, dadurch gekennzeichnet, daß in der Stufe b) der wäßrige Elektrolyt mindestens ein wasserlösliches oder in Wasser dispergierbares strahlungsempfindliches Diazoniumsalz in einem Anteil von 1 bis 150 g/l enthält.

10. Verfahren nach einem der Ansprüche 1 bis 9, dadurch gekennzeichnet, daß die elektrophoretische Beschichtung eine negativ-arbeitende strahlungsempfindliche Reproduktionsschicht ist, die auf ein mechanisch, chemisch und/oder elektrochemisch aufgerauhtes und gegebenenfalls anodisch oxidiertes Trägermaterial aus Aluminium oder einer seiner Legierungen aufgebracht wird.

11. Verfahren nach einem der Ansprüche 1 bis 10, dadurch gekennzeichnet, daß in der Stufe b) das Metallträgermaterial als Kathode in einem Gleichstromkreis geschaltet wird.

12. Verwendung eines nach einem der Ansprüche 1 bis 11 beschichteten Materials als Offsetdruckplatte.

## Claims

1. Process for the production of a metal support coated with a light-sensitive layer, comprising the steps of a) electrochemically treating one or both surfaces of the metal support material in an aqueous electrolyte to produce a hydrophilic intermediate layer and b) applying a lightsensitive layer, wherein in step a) the material is treated with an aqueous electrolyte containing at least one watersoluble compound selected from the group consisting of sulfonic, phosphonic and at least tribasic carboxylic acids, the phosphoric acid esters which still carry at least one acid functional group and the alkaline metal salts and ammonium salts of these acids or esters and in step b) a layer is applied from an electrolyte under the action of electric current, which electrolyte contains at least one radiation-sensitive compound which is soluble or dispersible in water.

2. A process as claimed in claim 1, wherein a layer is applied in step b), which additionally contains at least one binder which is soluble or dispersible in water.

3. A process as claimed in claim 1 or claim 2, wherein the aqueous electrolyte used in step a) contains at least one of the organic acids or esters in an amount ranging from 0.5 to 300 g/l and optionally additionally phosphoric acid and/or phosphorous acid.

4. A process as claimed in claim 1 or claim 2, wherein the aqueous electrolyte used in step a) contains at least one of the organic salts and additionally at least one salt having a silicate, fluoborate, tetraborate or pentaborate anion and a monovalent cation.

9

5. A process as claimed in claim 4, wherein in step a) organic salts are used which have an alkaline reaction in aqueous solution and are prepared from aqueous solutions of the acids or acid esters by titrating with an aqueous solution of an alkali metal hydroxide or ammonium hydroxide, until an alkaline pH is obtained.

6. A process as claimed in claim 5, wherein the aqueous solution contains from 1 to 80 g/l of acids or acid esters and the pH ranges from 8.0 to 10.5.

7. A process as claimed in any of claims 1 to 3, wherein the aqueous electrolyte used in step a) contains polybenzene phosphonic acid, phytic acid; polyvinyl phosphonic acid and/or 2-ethyl hexane phosphonic acid.

8. A process as claimed in claim 1, 4, 5 or 6, wherein the aqueous electrolyte used in step a) contains a salt of polyvinyl sulfonic acid, polyvinyl phosphonic acid, phytic acid, 2-ethyl hexane phosphonic acid and/or a salt of a hydrolized copolymer of vinyl methyl ether and maleic anhydride.

9. A process as claimed in any of claims 1 to 8, wherein the aqueous electrolyte used in step b) contains at least one radiation-sensitive diazonium salt which is soluble or dispersible in water, in an amount ranging from 1 to 150 g/l.

10. A process as claimed in any of claims 1 to 9, wherein the electrophoretic coating comprises a negative-working radiation-sensitive reproduction layer which is applied to a mechanically, chemically and/or electrochemically roughened and optionally anodically oxidized support material comprising aluminum or an aluminum alloy.

11. A process as claimed in any of claims 1 to 10, wherein in step b) the metal support is made the cathode in a d. c. circuit.

12. Use of a material which has been coated as claimed in any of claims 1 to 11 as an offset printing plate.

## Revendications

1. Procédé de fabrication d'un support métallique revêtu d'une couche photosensible, dans lequel a) on traite électrochimiquement la surface du matériau constituant le support métallique sur un côté ou des deux côtés avec un électrolyte aqueux pour obtenir une couche intermédiaire hydrophile et b) on applique une couche photosensible, caractérisé en ce que dans le stade a) on traite avec un électrolyte aqueux qui contient au moins un composé hydrosoluble choisi parmi les acides sulfoniques, phosphoniques ou carboxyliques au moins tribasiques, les esters phosphoriques présentant encore au moins un groupe fonctionnel acide et les sels alcalins ou les sels d'ammonium de ces acides ou esters, et dans le stade b) on applique une couche sous l'action d'un courant à partir d'un électrolyte qui contient au moins un composé photosensible hydrosoluble ou dispersable dans l'eau.

2. Procédé selon la revendication 1, caractérisé en ce que l'on applique au stade b) une couche qui contient en plus au moins un liant hydrosoluble ou dispersable dans l'eau.

3. Procédé selon la revendication 1 ou la revendication 2, caractérisé en ce que dans le stade a) l'électrolyte aqueux contient au moins l'un des acides ou esters organiques en une quantité représentant 0,5 à 300 g/l et éventuellement en plus de l'acide phosphorique et/ou de l'acide phosphoreux.

4. Procédé selon la revendication 1 ou la revendication 2, caractérisé en ce que dans le stade a) l'électrolyte aqueux contient au moins l'un des sels organiques et en plus au moins un sel avec un anion silicate, fluoborate, tétraborate ou pentaborate et un cation monovalent.

5. Procédé selon la revendication 4, caractérisé en ce que dans le stade a) on utilise des sels organiques qui réagissent de manière alcaline en solution aqueuse et qui sont obtenus à partir de solutions aqueuses des acides ou des esters acides par titrage avec une solution aqueuse d'hydroxyde alcalin ou d'ammonium jusqu'à l'obtention d'une valeur de pH alcalin.

6. Procédé selon la revendication 5, caractérisé en ce que la solution aqueuse contient de 1 à 80 g/l d'acides ou d'esters acides et le pH est de 8,0 à 10,5.

7. Procédé selon l'une quelconque des revendications 1 à 3, caractérisé en ce que dans le stade a) l'électrolyte aqueux contient de l'acide polybenzène phosphonique, de l'acide phytinique de l'acide polyvinyl phosphonique et/ou de l'acide 2-éthyl hexanephosphonique.

8. Procédé selon les revendications 1, 4, 5 ou 6, caractérisé en ce que dans le stade a) l'électrolyte aqueux contient un sel de l'acide polyvinylsulfonique, de l'acide polyvinylphosphonique, de l'acide phytinique, de l'acide 2-éthyl hexanephosphonique et/ou un sel d'un copolymère hydrolyse d'éther vinylméthylique et d'anhydride maléique.

9. Procédé selon l'une des revendications 1 à 8, caractérisé en ce que dans le stade b) l'électrolyte aqueux contient au moins un sel de diazonium photosensible, soluble dans l'eau ou dispersable dans l'eau en une quantité représentant de 1 à 150 g/l.

10. Procédé selon l'une des revendications 1 à 9, caractérisé en ce que la couche de revêtement électrophorétique est une couche de reproduction photosensible travaillant en négatif qui est appliquée sur un support grainé mécaniquement, chimiquement et/ou électrochimiquement et éventuellement oxydé par voie anodique en aluminium ou l'un de ses alliages.

11. Procédé selon l'une des revendications 1 à 10, caractérisé en ce que dans le stade b) le matériau de support métallique constitue la cathode dans un circuit en courant continu.

12. Utilisation d'un matériau revêtu selon l'une des revendications 1 à 11, comme plaque d'impression offset.